Europäisches Patentamt

European Patent Office

Office européen des brevets

(19)

(11) EP 0 667 660 B1

(12) **FASCICULE DE BREVET EUROPEEN**

(45) Date de publication et mention
de la délivrance du brevet:
**21.04.1999 Bulletin 1999/16**

(51) Int Cl.⁶: **H01S 3/103**, H01S 3/085

(21) Numéro de dépôt: **95400267.1**

(22) Date de dépôt: **09.02.1995**

(54) **Laser à réflecteurs de Bragg distribués, accordable en longueur d'onde, à réseaux de diffraction virtuels actives sélectivement**

Wellenlängeabstimmbarer Laser mit virtuellem, selektiv ansteuerbarem verteiltem Bragg Reflektor

Wavelength tunable distributed Bragg reflectionlaser with a virtual diffraction grating that can be selectively operated

(84) Etats contractants désignés:
**DE GB**

(30) Priorité: **11.02.1994 FR 9401577**

(43) Date de publication de la demande:
**16.08.1995 Bulletin 1995/33**

(73) Titulaire: **FRANCE TELECOM**
**75015 Paris (FR)**

(72) Inventeurs:
• **Delorme, Franck**
**F-94800 Villejuif (FR)**
• **Kazmierski, Christophe**
**F-91420 Morangis (FR)**

(74) Mandataire: **Dubois-Chabert, Guy et al**
**Société de Protection des Inventions**
**25, rue de Ponthieu**
**75008 Paris (FR)**

(56) Documents cités:
FR-A- 2 684 498    US-A- 3 814 498
US-A- 4 885 753

• **PATENT ABSTRACTS OF JAPAN vol. 8, no. 39 (E-228) 21 Février 1984 & JP-A-58 196 088 (HITACHI SEISAKUSHO KK)**
• **PATENT ABSTRACTS OF JAPAN vol. 13, no. 371 (E-807) 17 Août 1989 & JP-A-01 124 279 (MATSUSHITA ELECTRIC IND CO)**
• **PATENT ABSTRACTS OF JAPAN vol. 12, no. 304 (E-646) 18 Août 1988 & JP-A-63 073 585 (NEC CORP)**
• **IEEE JOURNAL OF QUANTUM ELECTRONICS., vol.29, no.6, Juin 1993, NEW YORK US pages 1817 - 1823 Y. TOHMORI ET AL 'Broad range wavelength tunable superstructure garting (SSG) DBR lasers'**

## Description

La présente invention concerne un laser à réflecteurs de Bragg distribués, accordable en longueur d'onde.

Elle s'applique notamment au domaine des télécommunications optiques et permet d'obtenir un laser mono-fréquence très largement accordable, utilisable en particulier pour la transmission d'informations par fibre optique.

On connaît divers lasers mono-fréquence à semiconducteurs, accordables en longueur d'onde.

Le laser à réflecteurs de Bragg distribués (« *Distributed Bragg Reflector Laser* »), ou laser DBR, est susceptible d'être accordé de façon discontinue (par sauts), avec une faible plage d'accord en longueur d'onde, de l'ordre de 10 nm.

A ce sujet, on se rapportera au document suivant :

(1) Y. Kotaki et al., « Wavelength tunable DFB and DBR lasers for coherent optical fibre communications », IEEE Proceedings-J; Vol.138, n°2, Avril 1991.

Ce laser DBR connu comprend une section active (partie amplificatrice) couplée optiquement à une section passive guidante où est gravé un réseau de Bragg qui permet une émission lumineuse mono-fréquence.

L'accord en longueur d'onde d'un tel laser s'obtient par injection de courant dans la section contenant ce réseau.

La variation du nombre de porteurs de charge dans cette section contribue à modifier l'indice optique effectif de cette section et donc la longueur d'onde d'émission du laser.

On connaît également d'autres lasers comprenant des réseaux de Bragg ou des guides de lumière plus complexes.

A ce sujet, on se reportera aux documents suivants :

(2) Y. Yoshikuni et al., « Broadly tunable Distributed Bragg Reflector lasers with a multiple-phase-shift super-structure grating », paper TuC2, p.8 Proceedings OFC/IOOC'93, San Jose, USA, 21-26 Février 1993. IEEE Photonics Techn. Lett., Vol.4, n°4, Avril 1992

(3) R.C. ALFERNESS et al,. « Broadly tunable InGaAsP/InP laser made based on vertical coupler filter with 57 nm tuning range », Appl. Phys. Letters, vol.60, n°26, 29 Juin 1992.

Ces autres lasers connus permettent d'obtenir un accord discontinu sur une plage de grande largeur, de l'ordre de 60 à 100 nm.

Pour tous les lasers connus mentionnés précédemment, la capacité d'accord en longueur d'onde, ou accordabilité en longueur d'onde, est fondée sur la variation de l'indice optique par injection de porteurs de charge dans une section de guidage de lumière qui comprend un réseau de Bragg plus ou moins complexe.

De plus, les principaux inconvénients de la plupart des autres lasers mentionnés plus haut en faisant référence aux documents (2) et (3) sont :

- la complexité du réseau Bragg ou du guide de lumière à réaliser,
- le nombre de courants électriques différents devant être maîtrisé pour obtenir cette accordabilité,
- le nombre limité de canaux de longueur d'onde accessibles,
- la difficulté de maîtriser l'espacement entre ces divers canaux de longueur d'onde, et
- les complications extrêmes auxquelles on est confronté pour accorder de façon continue ces lasers.

La présente invention a pour objet un laser à réflecteurs de Bragg distribués dont la plage d'accord en longueur d'onde est supérieure à celle des lasers DBR du genre de ceux du document (1) et qui a un grand nombre de canaux de longueur d'onde accessibles dans cette plage d'accord (ce qui n'est pas le cas des lasers connus par les documents (2) et (3) qui ont une plus grande plage d'accord mais un moins grand nombre de canaux de longueur d'onde que ceux du document (1)).

De plus, avec l'invention, il est facile de maîtriser l'espacement entre les canaux auxquels on peut accéder dans la plage totale d'accord en longueur d'onde.

La maîtrise des divers courants électriques nécessaires à l'accord en longueur d'onde d'un laser conforme à l'invention est également aisée.

Dans un mode de réalisation particulier de l'invention, il est possible d'obtenir une plage d'accord en longueur d'onde discontinue très importante avec un seul réseau de Bragg qui est facile à réaliser.

Le principe de la présente invention réside d'une part dans l'intégration en ligne (dans le sens de propagation de la lumière) d'une pluralité de structures constituant des réseaux de diffraction virtuels et correspondant respectivement à des longueurs d'onde de Bragg différentes les unes des autres (d'où des plages d'accord en longueur d'onde différentes les unes des autres) et d'autre part dans l'activation sélective, ou commutation sélective, de ces réseaux par injection de courant.

Il est alors possible d'obtenir un plage totale d'accord en longueur d'onde égale à plusieurs fois la plage d'accord correspondant à l'injection de courant dans un seul réseau (et donc nettement supérieure à celle des lasers DBR classiques du genre de ceux qui sont décrits dans le document (1)).

Dans le laser objet de la présente invention, un seul réseau de diffraction est actif à un moment donné.

En effet, dans le cas contraire, le réseau activé le plus proche de la partie active du laser masquerait l'effet du ou des autres réseaux activés.

Dans l'invention, l'injection d'un courant crée localement un réseau de diffraction puis permet d'accorder le laser.

La commutation du courant d'une section à l'autre de la partie passive du laser (chacune de ces sections correspondant à un réseau de diffraction) efface le réseau précédemment créé et définit un nouveau réseau qui est décalé en longueur d'onde de Bragg et qui est accordable sur d'autres canaux de longueur d'onde.

US-A-4 885 753 (OKAI et al.) décrit une technique destinée à augmenter l'accordabilité d'un laser DBR (laser à réflecteurs de Bragg distribués), technique qui consiste à changer localement le niveau de couplage de la lumière dans la section de rétroaction optique du laser, par délocalisation principale de la lumière dans l'un des deux guides constituant l'empilement vertical de cette section (coupleur co-directionnel), plus ou moins éloigné du réseau de diffraction correspondant.

JP-A-01 124 279 (MATSUSHITA ELECTRIC) décrit un laser <u>DFB</u> qui utilise principalement la modulation du courant injecté dans le laser pour engendrer la variation d'indice périodique qui est nécessaire à l'effet de rétroaction optique distribuée du laser DFB. Cette modulation de courant est engendrée par un réseau de diffraction gravé dans une couche semi-isolante.

FR-A-2 684 498 (MITSUBISHI DENKI KK) décrit un dispositif laser à semiconducteur à réaction répartie. Ce dispositif comprend une couche active, une couche de gaine adjacente 16 et, dans celle-ci, des couches de blocage de courant ayant un type de conductivité différent de celui de la couche de gaine. La couche active repose sur une couche de gaine inférieure ayant un type de conductivité différent de celui de la couche 16. Une polarisation appropriée de ce dispositif permet d'injecter des porteurs dans la couche active. On obtient ainsi une perturbation du coefficient de gain.

US-A-4 885 753 correspond au préambule de la revendication 1.

De façon précise, la présente invention a pour objet un laser à réflecteurs de Bragg distribués, accordable en longueur d'onde, conforme à la revendication 1.

Selon un premier mode de réalisation particulier du laser objet de l'invention, les agencements périodiques se trouvent dans l'une des première et deuxième couches semiconductrices de confinement et comprennent chacun une suite de zones semiconductrices alternativement de type P et de type N.

Selon un deuxième mode de réalisation particulier, les agencements périodiques se trouvent dans l'une des première et deuxième couches semiconductrice de confinement et comprennent chacun une suite de zones semiconductrices non dopées ou de zones semi-isolantes, alternant avec des zones semiconductrices ayant le même type de dopage que celui de la couche semiconductrice dans laquelle se trouvent ces agencements périodiques.

Dans une première réalisation particulière de l'invention, les sections de commutation ont le même indice optique effectif et les agencements périodiques correspondant respectivement à ces sections ont des périodes différentes les unes des autres.

Dans une deuxième réalisation particulière de l'invention, les sections de commutation ont des indices optiques effectifs différents les uns des autres et les agencements périodiques correspondant respectivement à ces sections ont la même période.

Dans une troisième réalisation particulière de l'invention, les sections de commutation ont des indices optiques effectifs différents les uns des autres et les agencements périodiques correspond respectivement à ces sections ont des périodes différentes les unes des autres.

Dans ces deuxième et troisième réalisations particulières de l'invention, l'une au moins des sections de commutation peut comprendre un empilement d'au moins deux couches de matériau dont les indices optiques sont différents l'un de l'autre et choisis pour conduire à l'indice optique effectif de cette section.

La partie passive du laser peut comprendre en outre une section intermédiaire, appelée section de phase, située entre les sections de commutation et la partie active du laser et permettant un accord continu de la longueur d'onde d'émission du laser par injection d'un courant électrique dans la partie de jonction P-N relative à cette section intermédiaire ou par polarisation en inverse de cette jonction.

Le laser objet de l'invention peut comprendre en outre des moyens d'injection de courant électrique sélectivement dans les parties de jonction P-N correspondant respectivement aux sections de commutation, chaque agencement périodique étant apte à moduler spatialement l'arrivée du courant électrique dans la partie de couche de guidage correspondant à cet agencement.

En variante, ce laser peut comprendre en outre des moyens de polarisation sélective en inverse des parties de jonction P-N correspondant respectivement aux sections de commutation, chaque agencement périodique étant apte à moduler spatialement le champ électrique dans la partie de jonction P-N correspondant à cet agencement.

La présente invention sera mieux comprise à la lecture de la description d'exemples de réalisation donnés ci-après, à titre purement indicatif et nullement limitatif, en faisant référence aux dessins annexés sur lesquels :

- la figure 1 est une vue schématique d'un mode de réalisation particulier du laser objet de l'invention,
- la figure 2 est une vue schématique d'un autre mode de réalisation particulier du laser objet de l'invention,

- les figures 3 à 5 sont des courbes relatives à l'accord en longueur d'onde d'un laser conforme à l'invention, du genre de celui de la figure 2, et
- les figures 6 à 9 illustrent schématiquement diverses étapes d'un procédé de fabrication d'un laser conforme à l'invention.

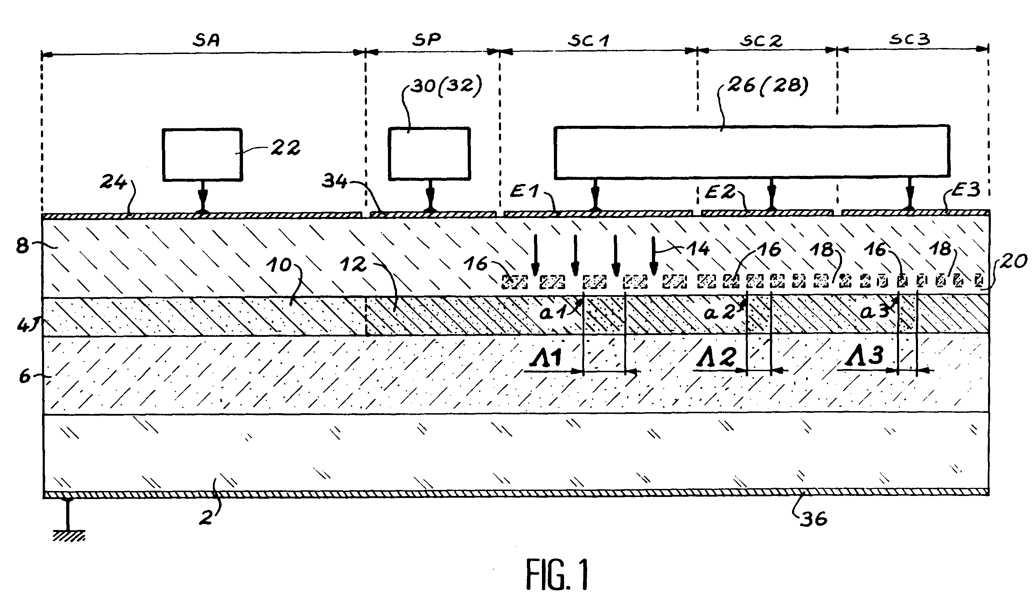

Le laser conforme à l'invention, qui est schématiquement représenté sur la figure 1, résulte de la modification d'un laser DBR classique et de l'introduction, dans la section de guidage de ce laser, de différents réseaux virtuels commutables à la place du réseau habituellement gravé dans cette section de guidage.

Pour obtenir la commutation effective des réseaux on utilise, au lieu du réseau de diffraction classique gravé de façon permanente dans une couche de guidage de lumière, des réseaux de diffraction virtuels qui sont activés par injection de porteurs de charge et qui présentent chacun l'avantage de n'exister que si un courant est injecté dans la section correspondante du laser, ce qui correspond parfaitement aux besoins d'un laser conforme à l'invention.

Le laser de la figure 1 comprend, sur un substrat semiconducteur 2, un empilement de couches semiconductrices qui comprend une couche semiconductrice 4 de guidage de lumière placée entre une couche semiconductrice inférieure 6 et une couche semiconductrice supérieure 8 dont les dopages sont opposés et qui forment ainsi une jonction P-N.

Ces couches 6 et 8 ont des largeurs de bande interdite supérieures à celle de la couche 4 et sont aptes à confiner la lumière dans cette couche 4.

Cette dernière comprend une partie active 10 constituant un milieu amplificateur de lumière et une partie passive 12 optiquement couplée à la partie active 10.

La partie active 10 et la partie passive 12 de la couche 4 définissent respectivement une partie active SA (ou section active) du laser et une partie passive (ou section passive) du laser.

Conformément à l'invention, cette partie passive du laser comprend une pluralité de sections de commutation.

Dans l'exemple représenté sur la figure 1 il y a trois sections de commutation respectivement référencées SC1, SC2 et SC3.

Le laser représenté sur la figure 1 comprend également, dans sa partie passive, une autre section SP appelée section de phase.

On reviendra par la suite sur cette section de phase SP.

Dans l'exemple représenté, la partie passive du laser est donc constituée par les sections SP, SC1, SC2 et SC3.

Chaque section de commutation comprend un agencement périodique formé dans la couche de confinement supérieur 8 et apte à moduler spatialement un courant électrique injecté dans la partie de la jonction P-N correspondant à cette section.

Dans l'exemple représenté, on a ainsi trois agencements périodiques a1, a2, a3 de ce genre, qui sont placés en série, le long de la partie passive 12 de la couche de guidage, et dont les périodes respectives sont notées $\Lambda 1$, $\Lambda 2$ et $\Lambda 3$.

Comme on le verra par la suite, on accorde le laser en injectant un courant électrique dans une section de commutation à la fois.

Dans l'exemple représenté, seule la jonction P-N de la section SC1 reçoit un courant électrique et l'on a symbolisé par des flèches 14 la modulation spatiale du courant électrique injecté.

Le courant ainsi modulé conduit à des variations de concentration des porteurs de charge dans la partie de la couche 4 correspondant à cette section.

A leur tour, ces porteurs de charge engendrent une modulation spatiale de l'indice optique dans cette partie de la couche 4.

On obtient ainsi un réseau d'indice dont le pas est égal à la période de l'agencement périodique considéré ($\Lambda 1$ pour la section SC1).

Dans l'exemple représenté sur la figure 1, la partie passive 12 (en matériau semiconducteur intrinsèque) de la couche 4 est comprise entre la couche de confinement inférieur 6 en matériau semiconducteur de type N et la couche de confinement supérieur 8 en matériau semiconducteur de type P, sur le substrat semiconducteur 2 de type N.

Chacun des agencements périodiques comprend des zones 16 qui sont faites d'un matériau semiconducteur de confinement optique, de type N, sont situées dans la couche 8 et peuvent être au voisinage de la partie 12 de la couche 4 (cas de la figure 1) ou en contact avec celle-ci.

Ces zones 16 alternent avec des zones 18 faites du matériau constitutif de la couche 8 (semiconducteur de type P).

On précise que l'épaisseur de la couche semiconductrice 20 de type P qui peut exister entre les agencements périodiques placés en série et la partie 12 de la couche 4 est très faible, par exemple inférieure à 50 nm.

Le laser représenté sur la figure 1 comprend également, dans la section active SA, des moyens 22 prévus pour injecter un courant électrique dans la couche 8, par l'intermédiaire d'une électrode 24 que comporte cette couche 8, en vue de provoquer une émission stimulée de lumière de la part de la partie active 10 de la couche 4.

Le laser de la figure 1 comprend également des moyens 26 prévus pour injecter un courant électrique dans la couche 8, dans l'une choisie des sections de commutation SC1, SC2 et SC3, respectivement par l'intermédiaire d'électrodes E1, E2 et E3 que comporte la couche 8, et pour polariser en direct la jonction P-N formée par les couches 6 et 8.

Les zones semiconductrices 16 bloquent, avec la période Λ1 ou Λ2 ou Λ3 (suivant la section choisie), l'arrivée du courant à la partie 12 de la couche 4.

En effet, au niveau de ces zones 16, on a des jonctions bloquantes de type P-N-I-N, alors qu'au niveau des zones 18, on a des jonctions passantes de type P-I-N.

Dans une variante non représentée du laser de la figure 1, le substrat 2 est de type P, il en est de même pour la couche 6 et la couche 8 est de type N.

Les zones 16 sont alors de type P et alternent avec des zones 18 de la couche 8 (de type N).

Dans une autre variante non représentée, les zones 16 sont remplacées par des zones faites d'un matériau semi-isolant ou d'un matériau semiconducteur non dopé, et les zones 18, qui font partie de la couche 8, sont de type P (respectivement N) si la couche 8 est de type P (respectivement N), auquel cas la couche 6 est bien entendu de type N (respectivement P).

Dans un autre laser conforme à l'invention, on remplace les moyens 26 par des moyens 28 qui sont prévus pour polariser en inverse, de façon sélective, les parties de jonction P-N correspondant respectivement aux sections SC1, SC2 et SC3.

Dans ce cas, c'est la modulation spatiale du champ électrique dans la partie de jonction P-N ainsi polarisée en inverse (et donc dans la partie de couche de guidage correspondante) qui crée le réseau d'indice grâce à des effets électro-optiques.

La section de phase SP, qui est facultative, permet un accord en continu du laser de la figure 1.

Pour ce faire, cette section de phase SP est munie de moyens 30 d'injection de courant dans la partie correspondante de la couche 8, par l'intermédiaire d'une électrode 34 dont est munie cette couche 8, comme on le voit sur la figure 1.

En variante, on peut utiliser des moyens 32 de polarisation en inverse de la partie de jonction P-N correspondant à cette section SP.

Dans le laser de la figure 1, le substrat 2 est muni d'une électrode 36 mise à la masse.

L'activation du réseau virtuel de diffraction de l'une des sections SC1, SC2 et SC3, grâce aux moyens 26 (ou aux moyens 28), permet de faire apparaître dans la section choisie un réseau de diffraction dont on peut d'ailleurs moduler l'amplitude.

On dispose ainsi d'un réseau de Bragg constitué par l'association de ce réseau de diffraction et de la partie de couche de guidage 4 correspondante.

Ce réseau de Bragg est caractérisé par une longueur d'onde de Bragg notée λB1 pour la section SC1, λB2 pour la section SC2 et λB3 pour la section SC3.

Cette longueur d'onde de Bragg est reliée à l'indice optique effectif Neff du guide optique constitué par la partie passive 12 de la couche de guidage et par les couches de confinement 6 et 8 ainsi qu'au pas Λ1 ou Λ2 ou Λ3 du réseau de diffraction activé correspondant et à l'ordre p de ce réseau de diffraction par la formule suivante :

$$\lambda Bi = \Lambda i.2Neff/p.$$

Dans cette formule, l'indice i prend l'une des valeurs 1, 2 et 3 suivant la section dont il s'agit.

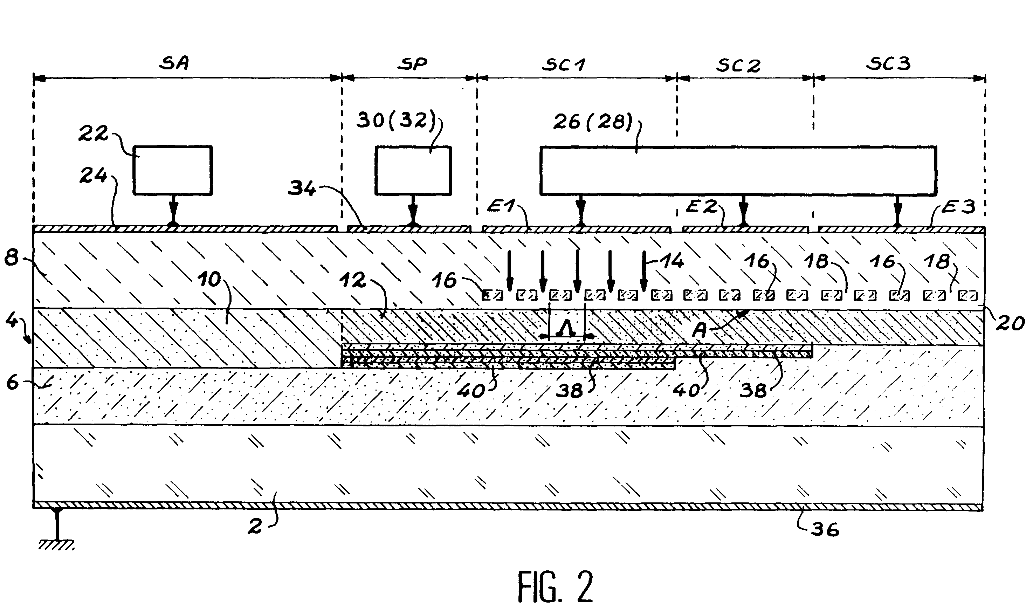

Un autre laser conforme à l'invention est schématiquement représenté sur la figure 2.

Dans cette autre laser, il n'y a qu'un seul agencement périodique A, de période Λ, qui s'étend le long de la partie passive 12 de la couche de guidage de lumière 4.

Autrement dit, tous les agencements périodiques placés en série de la figure 1 ont maintenant la même période Λ.

Mais, contrairement au cas du laser de la figure 1, dans lequel l'indice effectif du guide optique de la partie passive du laser est constant, les sections de commutation SC1, SC2 et SC3 du laser de la figure 2 ont des indices optiques effectifs différents les uns des autres.

On fait encore apparaître un réseau de diffraction dans celle des sections de commutation que l'on a choisie, grâce aux moyens 26 (ou aux moyens 28) mais, dans le cas de la figure 2, le réseau de Bragg correspondant à la section de commutation activée est caractérisé par une longueur d'onde de Bragg qui est donnée par la formule suivante :

$$\lambda Bi = \Lambda.2Ni/p.$$

Dans cette formule, l'indice i prend l'une des valeurs 1, 2 et 3 suivant la section de commutation choisie et Ni représente l'indice optique effectif 5X26 (o correspondant à cette section.

Ainsi, dans le cas de la figure 2, pour réaliser les réseaux qui ont le même pas et sont nécessaires à l'obtention des différentes longueurs d'onde de Bragg, on n'a besoin que d'un seul agencement périodique constitué de l'alternance des zones 16 et 18 mais il faut modifier localement l'indice optique effectif du guide optique de la section passive du laser.

Pour ce faire, on ajoute à cette partie passive des couches alternées d'un premier matériau et d'un deuxième matériau qui ont des indices optiques différents l'un de l'autre.

Plus précisément, dans le laser de la figure 2, la partie passive de la couche de guidage de lumière 12 est munie, du côté de la couche de confinement inférieur 6, d'un empilement de couches 38 d'un premier matériau d'indice optique n1 qui alterne avec des couches 40 d'un deuxième matériau d'indice optique n2 différent de n1.

Ces couches 38 et 40 n'ont pas nécessairement la même épaisseur.

On voit sur la figure 2 que cet empilement des couches 38 et 40 alternées a été gravé pour présenter des marches d'escalier.

A une extrémité de l'empilement, toutes les couches 38 et 40 subsistent tandis qu'à l'autre extrémité, aucune des couches 38 et 40 ne subsiste.

On passe d'une marche à la suivante en supprimant un couple de couches 38 et 40.

Dans l'exemple représenté sur la figure 2, il y a deux couples de couches 38 et 40 d'où deux marches et donc trois zones correspondant respectivement aux trois sections de commutation.

L'empilement des couches 38 et 40 s'étend également dans la section de phase SP, pour simplifier la fabrication du laser, mais il pourrait être supprimé dans cette section de phase.

Ce sont ces zones qui permettent, en association avec les réseaux de diffraction correspondant, d'obtenir trois réseaux de Bragg et donc d'obtenir les trois longueurs d'onde de Bragg respectivement notés λB1, λB2 et λB3.

Le laser conforme à l'invention, qui est schématiquement représenté sur la figure 2, est plus simple à fabriquer que celui de la figure 1 du fait qu'il ne nécessite qu'un seul agencement périodique quel que soit le nombre de sections de commutation à réaliser.

Comme précédemment, un réseau de diffraction n'existe dans une section de commutation que l'on a sélectionnée que si l'on injecte un courant dans cette section.

Dans le cas de la figure 2, il s'agit de la section SC1 et les flèches 14 symbolisent la modulation du courant injecté dans cette section.

A titre purement indicatif et nullement limitatif, on peut réaliser un laser conforme à l'invention ayant une section active dont la longueur vaut 500 μm, une section de phase dont la longueur vaut 100 μm et trois sections de commutation à réseau virtuel qui ont chacune une longueur de 150 μm, en utilisant le matériau InP pour les couches de confinement de ce laser, le matériau actif du laser étant InGaAsP 1,55 μm et la partie passive de la couche de guidage de lumière étant faite en InGaAsP 1,3 μm.

On utilise un seul agencement périodique que l'on réalise avec des couches de InP respectivement dopées N et P.

Les longueurs d'onde de Bragg des trois sections valent respectivement λB1=1,540 μm, λB2=1,532 μm et λB3=1,524 μm.

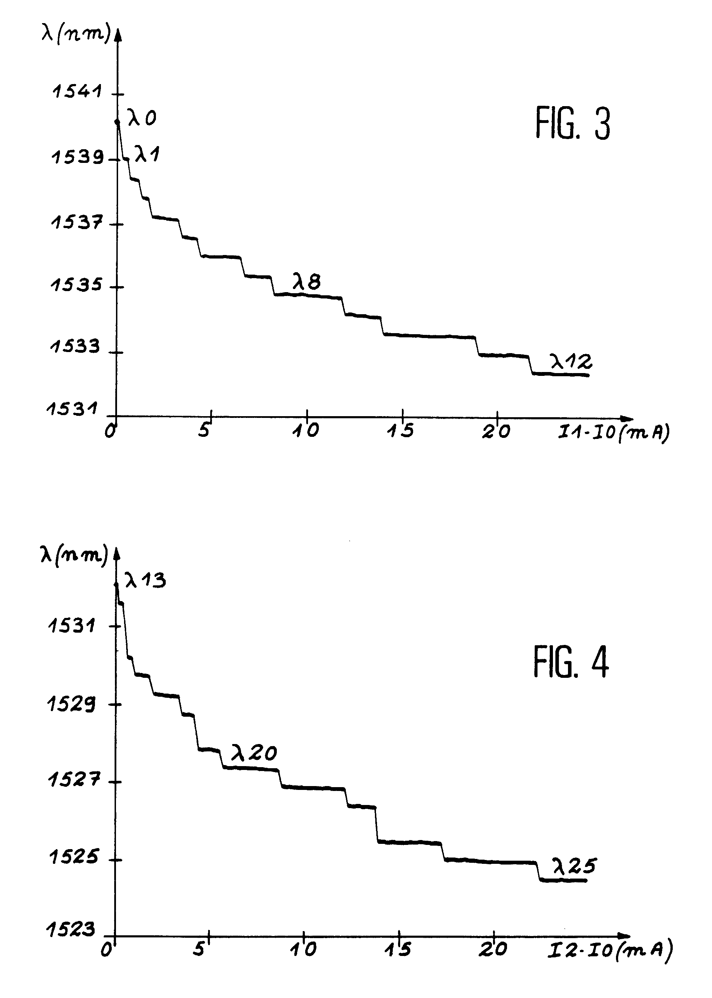

Les courbes des figures 3, 4 et 5 représentent les résultats relatifs à la capacité d'accord en longueur d'onde que l'on peut obtenir avec un tel laser conforme à l'invention.

Chacune des courbes des figures 3 à 5 représente les variations de la longueur d'onde d'émission λ du laser (exprimée en nm) en fonction de la différence (exprimée mA) entre l'intensité du courant injecté dans la section correspondant à la courbe considérée et l'intensité I0 du faible courant qui est nécessaire pour la création du réseau de diffraction correspondante.

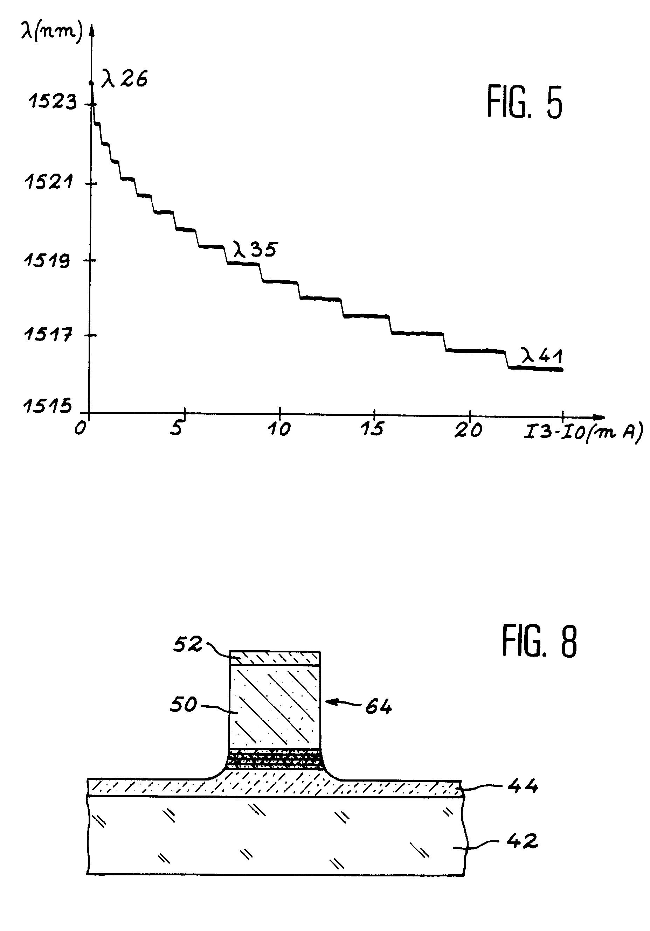

L'intensité du courant injecté est notée I1 pour la section SC1 (figure 3), I2 pour la section SC2 (figure 4) et I3 pour la section SC3 (figure 5).

Dans le cas de la figure 3, seul le réseau de la section SC1 est actif, dans le cas de la figure 4 seul le réseau de la section SC2 est actif et dans le cas de la figure 5, seul le réseau de la section SC3 est actif.

On voit sur la figure 3 la plage d'accord obtenue pour un courant injecté dans la section SC1, sur la figure 4, la plage d'accord obtenue pour un courant injecté dans la section SC2 et sur la figure 5 la plage d'accord obtenue pour un courant injecté dans la section SC3.

Pour la figure 3, on obtient treize canaux de longueur d'onde respectivement notés λ0, λ1 ... λ12.

Pour la figure 4, on obtient treize canaux de longueur d'onde respectivement notés λ13 ... λ25.

Pour la figure 5, on obtient seize canaux de longueur d'onde respectivement notés λ26 ... λ41.

La différence entre les longueurs d'onde des canaux extrêmes vaut

- dans le cas de la figure 3 : λ12 - λ0 = 7,88 nm
- dans le cas de la figure 4 : λ25 - λ13 = 7,68 nm
- dans le cas de la figure 5 : λ41 - λ26 = 7,55 nm.

La somme des plages d'accord en longueur d'onde des trois sections de commutation est supérieure à la plage d'accord relative à un laser DBR classique, du genre de celui qui est décrit dans le document (1) mentionné plus haut, où cette plage vaut 10 nm, alors que dans le cas présent la plage d'accord totale vaut environ 24 nm c'est-à-dire trois fois celle qui est obtenue par injection de courant dans une seule section de commutation comme par exemple la section SC2, qui correspond à une plage d'accord d'environ 8 nm.

On précise que dans le cas des figures 3, 4 et 5, les courbes sont tracées en supposant qu'aucun courant n'est injecté dans la section de phase du laser.

Comme on l'a déjà évoqué plus haut, l'intérêt supplémentaire d'un laser conforme à l'invention est la possibilité d'avoir une accordabilité continue par injection de courant dans la section de phase SP.

Cette accordabilité continue, est, comme pour l'accordabilité discontinue, multipliée par le nombre de sections de commutation du laser.

Ainsi, de façon avantageuse, on obtient un fonctionnement similaire à celui d'un laser DBR classique pour chaque section de commutation.

De ce fait, la fabrication d'un laser conforme à l'invention est simple par comparaison avec la fabrication d'autres lasers DBR largement accordables dont il a été question plus haut.

La maîtrise tant de l'espacement entre les canaux de longueur d'onde (hauteur des marches des figures 3 à 5) que du nombre de ces canaux et la commande des divers courants utilisés pour changer la longueur d'onde du laser est plus simple par comparaison avec les lasers DBR connus largement accordables.

En revenant aux figures 3 à 5, on précise que, si l'intensité du courant de la section de phase n'est pas nulle, on obtient une courbe du même genre que celles de ces figures mais décalée faiblement vers le bas, au maximum d'un canal de longueur d'onde.

On précise qu'on peut également réaliser un laser conforme à l'invention ayant, comme celui de la figure 1, des agencements périodiques de périodes différentes et, comme celui de la figure 2, des couples de couches qui modifient localement l'indice optique effectif dans la partie passive du laser.

On indique également que l'on pourrait réaliser un laser conforme à l'invention dans lequel les agencements périodiques seraient dans la couche de confinement inférieur et les couches de modification d'indice optique effectif seraient dans la couche de confinement supérieur.

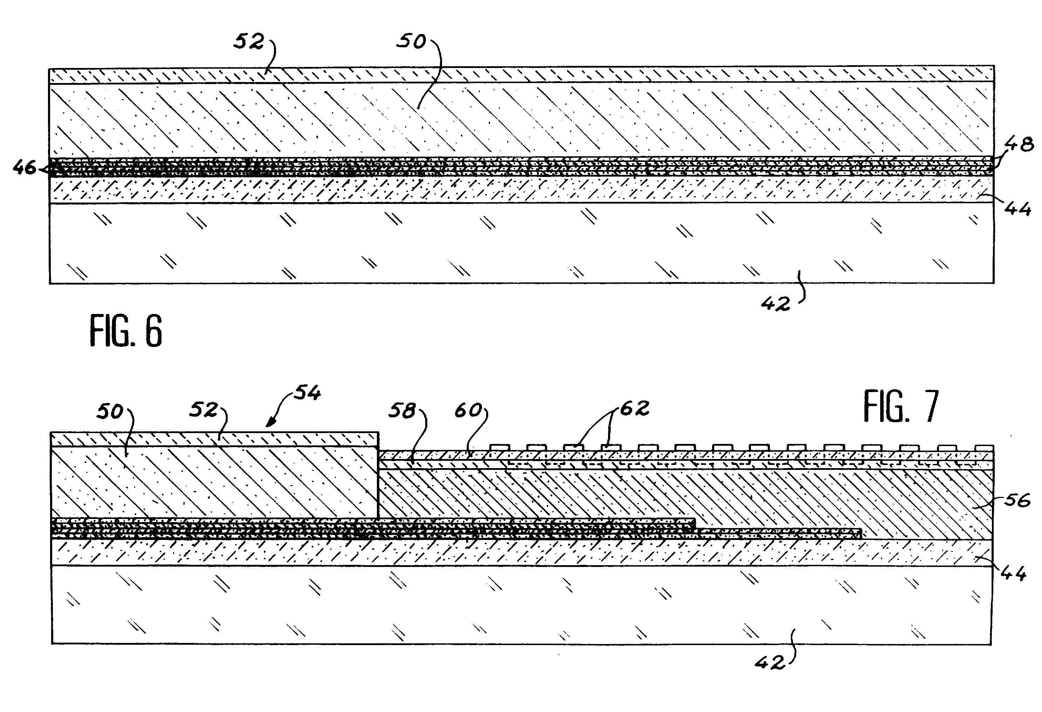

On décrit ci-après, en faisant référence aux figures 6 à 9, un exemple de procédé de fabrication d'un laser conforme à l'invention, comprenant un seul réseau de diffraction virtuel pour trois sections de commutation respectivement associées à des indices optiques effectifs différents les uns des autres, comme dans le cas de la figure 2.

Selon une première étape de ce procédé (figure 6), on fait croît par épitaxie, sur un substrat 42 en InP dopé N+ :

- une couche - tampon 44 en InP dopé N+,
- deux couples de couches 46 et 48 nécessaires à définir les trois zones d'indices optiques effectifs différents, les deux couches 46 étant en InGaAsP non dopé et les deux couches 48 étant en InP dopé N,
- la couche active 50 en InGaAsP 1,5 μm non dopé (la composition de cette couche correspondant à une émission lumineuse dans le domaine centré sur 1,5 μm),
- une couche de protection 52 en InP dopé.

Dans une deuxième étape illustrée schématiquement par la figure 7, on grave les couches 52 et 50 pour délimiter la partie active 54 du laser.

Dans une troisième étape (figure 7), on grave les couples de couches 46 et 48 de façon à délimiter les trois sections de commutation du laser correspondant à des indices optiques effectifs différents les uns des autres.

Dans une quatrième étape (figure 7), on fait croître successivement par épitaxie sélective, les couches suivantes dans les parties autres que la partie active du laser :

- une couche 56 en InGaAsP 1,3 μm,
- une couche 58 en InP dopé P+,

- une couche 60 en InP dopé N+, ces couches 58 et 60 étant destinées à l'obtention de l'agencement périodique mentionné plus haut.

Dans une cinquième étape (figure 7), on enlève la partie de la couche 60 en InP dopé N+ dans la section de phase du laser et l'on grave l'agencement périodique permettant d'obtenir le réseau de diffraction virtuel, dans les trois sections de commutation, à travers un masque 62 obtenu par un masqueur électronique ou par une insolation holographique.

Dans une sixième étape, on grave le ruban 64 du laser perpendiculairement aux traits du réseau de diffraction.

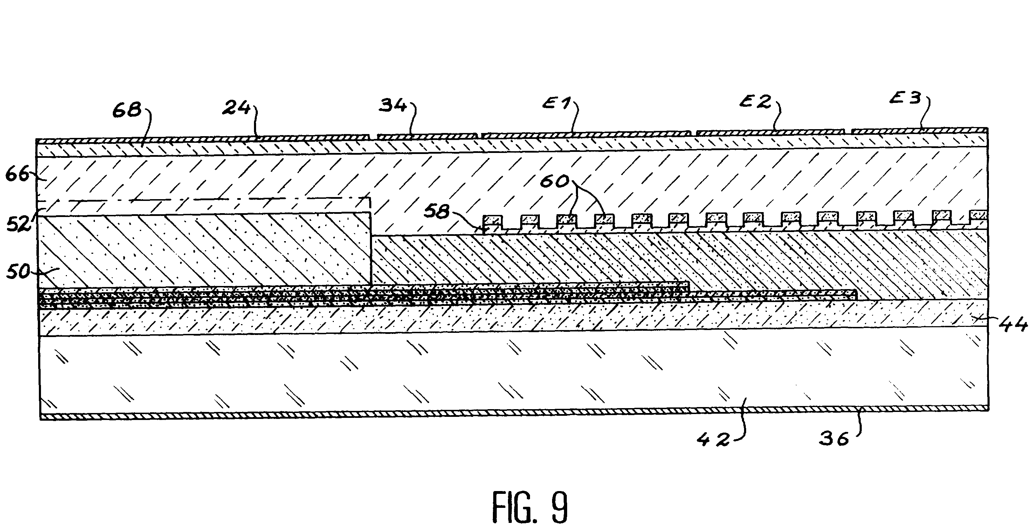

Cette étape est schématiquement illustrée par la figure 8 qui est une vue en coupe transversale de la partie active du laser en cours de fabrication.

Dans une septième étape (figure 9), on effectue une reprise d'épitaxie.

Plus précisément, on forme par épitaxie la couche 66 de confinement supérieur du laser en InP dopé P+, puis une couche de contact 68 en InGaAs dopé P+.

Dans une huitième étape (figure 9) où le laser est vu en coupe longitudinale suivant le sens de propagation de la lumière (comme c'est d'ailleurs le cas pour les figures 6 et 7), on réalise le contact métallique inférieur 36, sur le substrat 42 ainsi que les divers contacts métalliques supérieurs des diverses parties du laser, à savoir :

- le contact 24 correspondant à la partie active du laser,
- le contact 34 correspondant à la section de phase du laser, et
- les contacts E1, E2 et E3 correspondant respectivement aux trois sections de commutation du laser.

## Revendications

1. Laser à réflecteurs de Bragg distribués, accordable en longueur d'onde, comprenant, entre des première (6) et deuxième (8) couches semiconductrices de confinement de lumière, une couche semiconductrice de guidage de lumière (4) qui comprend une partie active (10) constituant un milieu amplificateur de lumière et définissant une partie active du laser, et une partie passive (12) optiquement couplée à la partie active de la couche de guidage et définissant une partie passive du laser, les couches de confinement ayant des types de dopage opposés l'un à l'autre et formant ainsi une jonction P-N, caractérisé en ce que la partie passive du laser comprend une pluralité de sections de commutation (SC1, SC2, SC3), chaque section de commutation comprenant un agencement périodique (a1, a2, a3; A) apte à moduler spatialement la répartition des porteurs de charge ou le champ électrique dans la partie passive de la couche de guidage contenue dans cette section, lorsqu'un courant électrique est injecté dans la partie de jonction P-N relative à cette section ou que cette partie de jonction P-N est polarisée en inverse, de manière à créer, dans cette section, un réseau de diffraction dont le pas est égal à la période de l'agencement, chaque section ayant en outre un indice optique effectif déterminé, apte à coopérer avec le réseau de diffraction correspondant pour conduire à une longueur d'onde de Bragg déterminée pour cette section, de sorte que le laser est accordable en longueur d'onde par activation sélective des réseaux de diffraction un seul réseau de diffraction étant actif à un moment donné.

2. Laser selon la revendication 1, caractérisé en ce que les agencements périodiques se trouvent dans l'une des première (6) et deuxième (8) couches semiconductrices de confinement et comprennent chacun une suite de zones semiconductrices (16, 18) alternativement de type P et de type N.

3. Laser selon la revendication 1, caractérisé en ce que les agencements périodiques se trouvent dans l'une des première (6) et deuxième (8) couches semiconductrices de confinement et comprennent chacun une suite de zones semiconductrices non dopées ou de zones semi-isolantes, alternant avec des zones semiconductrices ayant le même type de dopage que celui de la couche semiconductrice dans laquelle se trouvent ces agencements périodiques.

4. Laser selon l'une quelconque des revendications 1 à 3, caractérisé en ce que les sections de commutation (SC1, SC2, SC3) ont le même indice optique effectif et en ce que les agencements périodiques (a1, a2, a3) correspondant respectivement à ces sections ont des périodes différentes les unes des autres.

5. Laser selon l'une quelconque des revendications 1 à 3, caractérisé en ce que les sections de commutation (SC1, SC2, SC3) ont des indices optiques effectifs différents les uns des autres et en ce que les agencements périodiques (A) correspondant respectivement à ces sections ont la même période.

6. Laser selon l'une quelconque des revendications 1 à 3, caractérisé en ce que les sections de commutation (SC1, SC2, SC3) ont des indices optiques effectifs différents les uns des autres et en ce que les agencements périodiques correspondant respectivement à ces sections ont des périodes différentes les unes des autres.

7. Laser selon l'une quelconque des revendications 5 et 6, caractérisé en ce que l'une au moins des sections de commutation comprend un empilement d'au moins deux couches de matériaux (28, 40) dont les indices optiques sont différents l'un de l'autre et choisis pour conduire à l'indice optique effectif de cette section.

8. Laser selon l'une quelconque des revendications 1 à 7, caractérisé en ce que la partie passive du laser comprend en outre une section intermédiaire (SP), appelée section de phase, située entre les sections de commutation (SC1, SC2, SC3) et la partie active (SA) du laser et permettant un accord continu de la longueur d'onde d'émission du laser par injection d'un courant électrique dans la partie de jonction P-N relative à cette section intermédiaire ou par polarisation en inverse de cette jonction.

9. Laser selon l'une quelconque des revendications 1 à 8, caractérisé en ce qu'il comprend en outre des moyens (26) d'injection de courant électrique sélectivement dans les parties de jonction P-N correspondant respectivement aux sections de commutation, chaque agencement périodique étant apte à moduler spatialement l'arrivée du courant électrique dans la partie de couche de guidage correspondant à cet agencement.

10. Laser selon l'une quelconque des revendications 1 à 8, caractérisé en ce qu'il comprend en outre des moyens (28) de polarisation sélective en inverse des parties de jonction P-N correspondant respectivement aux sections de commutation, chaque agencement périodique étant apte à moduler spatialement le champ électrique dans la partie de jonction P-N correspondant à cet agencement.

**Patentansprüche**

1. Wellenlängenabstimmbarer Laser mit verteiltem Bragg-Reflektor, zwischen einer ersten (6) und einer zweiten (8) Lichteinschließungs-Halbleiterschicht eine Lichtleitschicht (4) enthaltend, die einen ein Lichtverstärkungsmedium bildenden und einen aktiven Teil des Lasers definierenden aktiven Teil (10) umfaßt und einen passiven Teil (12), der mit dem aktiven Teil der Leitschicht optisch gekoppelt ist und einen passiven Teil des Lasers definiert, wobei die Einschließungsschichten einander entgegengesetzte Dotierungstypen aufweisen und somit einen P-N-Übergang bilden,
**dadurch gekennzeichnet,**
daß der passive Teil des Lasers eine Mehrzahl Umschaltsektionen (SC1, SC2, SC3) aufweist, wobei jede Umschaltsektion eine periodische Anordnung (a1, a2, a3; A) umfaßt, fähig räumlich die Verteilung der Ladungsträger oder das elektrische Feld in dem passiven Teil der in dieser Sektion enthaltenen Leitschicht anzupassen, wenn ein elektrischer Strom in den diese Sektion betreffenden Teil des P-N-Übergangs eingespeist wird oder wenn dieser P-N-Übergangsteil invers gepolt wird, um in dieser Sektion ein Beugungsgitter zu erzeugen, dessen Teilung gleich der Periode der Anordnung ist, und jede Sektion außerdem einen festgelegten effektiven optischen Index hat, der geeignet ist, mit dem entsprechenden Beugungsgitter zusammenzuwirken, um zu einer für diese Sektion festgelegten Bragg-Wellenlänge zu führen, so daß der Laser durch selektive Aktivierung des Beugungsgitters wellenlängenabstimmbar ist, wobei zu einem bestimmten Zeitpunkt ein einziges Beugungsgitter aktiv ist.

2. Laser nach Anspruch 1, dadurch gekennzeichnet, daß die periodischen Anordnungen sich in einer der Halbleiter-Einschließungsschichten (6, 8) befinden und jede eine Folge von Halbleiterzonen (16, 18), abwechselnd vom Typ P und vom Typ N, umfaßt.

3. Laser nach Anspruch 1, dadurch gekennzeichnet, daß die periodischen Anordnungen sich in einer der Halbleiter-Einschließungsschichten (6, 8) befinden und jede eine Folge von nichtdotierten Halbleiterzonen (16, 18) oder semi-isolierenden Zonen umfaßt, die sich abwechseln mit Halbleiterzonen desselben Dotierungstyps wie dem der Halbleiterschicht, in der sich diese periodischen Anordnungen befinden.

4. Laser nach einem der Ansprüche 1 bis 3, dadurch gekennzeichnet, daß die Umschaltsektionen (SC1, SC2, SC3) denselben effektiven optischen Index haben, und dadurch, daß die jeweils diesen Sektionen entsprechenden periodischen Anordnungen (al, a2, a3) Perioden haben, die sich voneinander unterscheiden.

5. Laser nach einem der Ansprüche 1 bis 3, dadurch gekennzeichnet, daß die Umschaltsektionen (SC1, SC2, SC3) effektive optische Indices haben, die sich voneinander unterscheiden, und dadurch, daß die periodischen Anordnungen (A), die jeweils diesen Sektionen entsprechen, dieselbe Periode haben.

6. Laser nach einem der Ansprüche 1 bis 3, dadurch gekennzeichnet, daß die Umschaltsektionen (SC1, SC2, SC3) effektive optische Indices haben, die sich voneinander unterscheiden, und dadurch, daß die jeweils diesen Sektionen entsprechenden periodischen Anordnungen Perioden haben, die sich voneinander unterscheiden.

7. Laser nach einem der Ansprüche 5 und 6, dadurch gekennzeichnet, daß wenigstens eine der Umschaltsektionen einen Stapel von wenigstens zwei Schichten (28, 40) eines Materials umfaßt, dessen optische Indizes sich voneinander unterscheiden und gewählt werden, um zum effektiven optischen Index dieser Sektion zu führen.

8. Laser nach einem der Ansprüche 1 bis 7, dadurch gekennzeichnet, daß der passive Teil des Lasers außerdem eine Zwischensektion (SP) umfaßt, Phasensektion genannt, die sich zwischen den Umschaltsektionen (SC1, SC2, SC3) und dem aktiven Teil (SA) des Lasers befindet und eine kontinuierliche Abstimmung der Emissionswellenlänge des Lasers durch Einspeisung eines elektrischen Stroms in den diese Zwischensektion betreffenden Teil des P-N-Übergangs oder durch inverse Polung dieses Übergangs ermöglicht.

9. Laser nach einem der Ansprüche 1 bis 8, dadurch gekennzeichnet, daß er außerdem Einrichtungen (26) zum selektiven Einspeisen von elektrischem Strom in die jeweils den Umschaltsektionen entsprechenden Teile des P-N-Übergangs umfaßt, wobei jede periodische Anordnung fähig ist, das Eintreffen des elektrischen Stroms in dem dieser Anordnung entsprechenden Teil der Leitschicht räumlich anzupassen.

10. Laser nach einem der Ansprüche 1 bis 8, dadurch gekennzeichnet, daß er außerdem Einrichtungen (28) zur selektiven inversen Polung der den jeweiligen Umschaltsektionen entsprechenden Teilen des P-N-Übergangs umfaßt, wobei jede periodischen Anordnung fähig ist, das elektrische Feld in dem dieser Anordnung entsprechenden P-N-Übergangsteil räumlich anzupassen.

## Claims

1. Wavelength-tunable, distributed Bragg reflector laser, comprising between first (6) and second (8) light semiconductor confinement layers, a light guiding semiconductor layer (4) having an active part (10) constituting a light amplifying medium and defining an active part of the laser, and a passive part (12) optically coupled to the active part of the guide layer and defining a passive part of the laser, the confinement layers having opposite doping types, which thus form a p-n junction, characterized in that the passive part of the laser has a plurality of switching sections (SC1, SC2, SC3), each switching section comprising a periodic arrangement (a1, a2, a3, A) able to spatially modulate the distribution of the charge carriers or the electric field in the passive part of the guide layer contained in said section, when an electric current is injected into the p-n junction part relative to said section or said p-n junction part is reverse biased, so as to create, in said section, a diffraction grating whose pitch spacing is equal to the period of the arrangement, each section also having a given, effective optical index able to cooperate with the corresponding diffraction grating in order to lead to a predetermined Bragg wavelength for said section, so that the laser is wavelength-tunable by selective activation of the diffraction gratings, a single diffraction grating being active at a given moment.

2. Laser according to claim 1, characterized in that the periodic arrangements are located in one of the first (6) and second (8) semiconductor confinement layers and in each case comprise a sequence of semiconductor zones (16, 18), alternately of type p and type n.

3. Laser according to claim 1, characterized in that the periodic arrangements are located in one of the first (6) and second (8) semiconductor confinement layers and in each case comprise a sequence of undoped semiconductor zones or semi-insulating zones, alternating with semiconductor zones having the same doping type as that of the semiconductor layer in which these periodic arrangements are located.

4. Laser according to any one of the claims 1 to 3, characterized in that the switching sections (SC1, SC2, SC3) have the same effective optical index and in that the periodic arrangements (a1, a2, a3) respectively corresponding to these sections have different periods.

5. Laser according to any one of the claims 1 to 3, characterized in that the switching sections (SC1, SC2, SC3) have different effective optical indexes and in that the period arrangements (A) respectively corresponding to these sections have the same period.

6. Laser according to any one of the claims 1 to 3, characterized in that the switching sections (SC1, SC2, SC3) have different effective optical indexes and in that the periodic arrangements respectively corresponding to these sections have different periods.

7. Laser according to either of the claims 5 and 6, characterized in that at least one of the switching sections incorporates a stack of at least two layers of materials (28, 40) having different optical indexes and chosen in order to bring about the effective optical index of said section.

8. Laser according to any one of the claims 1 to 7, characterized in that the passive part of the laser also incorporates an intermediate section (SP), known as the phase section, positioned between the switching sections (SC1, SC2, SC3) and the active part (SA) of the laser and permitting a continuous tuning of the emission wavelength of the laser by injecting an electric current into the p-n junction part relative to said intermediate section or by reverse biasing of said junction.

9. Laser according to any one of the claims 1 to 8, characterized in that it also incorporates means (26) for injecting an electric current selectively into the p-n junction parts respectively corresponding to the switching sections, each periodic arrangement being able to spatially modulate the entry of electric current into the guidance layer part corresponding to said arrangement.

10. Laser according to any one of the claims 1 to 8, characterized in that it also incorporates means (28) for the selective reverse biasing of the p-n junction parts respectively corresponding to the switching sections, each periodic arrangement being able to spatially modulate the electric field in the p-n junction part corresponding to said arrangement.

FIG.1

FIG. 2

EP 0 667 660 B1

FIG. 3

FIG. 4

FIG. 5

FIG. 8

FIG. 6

FIG. 7

EP 0 667 660 B1

FIG. 9